# EUROPÄISCHE PATENTSCHRIFT

(11) **EP 1 919 004 B1**
(45) Veröffentlichungstag und Bekanntmachung des Hinweises auf die Patenterteilung: **14.11.2012**
(21) Anmeldenummer: 07116822.3
(22) Anmeldetag: 20.09.2007
(51) Int. Cl.: H01L 41/053, F02M 51/06

(54) **Piezoaktormodul oder Piezoaktor mit einem ummantelnden Schutzschichtsystem**
Piezo actuator module or piezo actuator with a cladded protection layer system
Module de piézoacteur ou piézoacteur doté d'un système de couche de protection gainé

(30) Priorität: 31.10.2006 DE 102006051328
(43) Veröffentlichungstag der Anmeldung: 07.05.2008
(73) Patentinhaber: ROBERT BOSCH GMBH, 70442 Stuttgart (DE)
(72) Erfinder: Cromme, Peter, 96050 Bamberg (DE); Liebscher, Claudia, 96047 Bamberg (DE); Sommariva, Helmut, 8053 Graz (AT)

(56) Entgegenhaltungen:
- EP-A1- 0 055 531
- WO-A1-2007/131965
- DE-A1- 10 237 589
- DE-A1- 19 818 068

## Beschreibung

### Stand der Technik

Die Erfindung betrifft einen zumindest teilweise ummantelten, beispielsweise von flüssigen Medien umströmten Piezoaktor oder ein Piezoaktormodul mit einem Schutzschichtsystem nach den gattungsgemäßen Merkmalen der Ansprüche 1 oder 2.

Es ist an sich bekannt, dass zum Aufbau des zuvor erwähnten Piezoaktors Piezoelemente so eingesetzt werden, dass unter Ausnutzung des sogenannten Piezoeffekts eine Steuerung des Nadelhubes eines Ventils oder dergleichen vorgenommen werden kann. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors aus der DE 10026005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Stapel mehrerer elektrisch und mechanisch miteinander gekoppelter Piezoelemente vorhanden, der über einen Aktorfuß und einen Aktorkopf unter Vorspannung zwischen zwei Anschlägen gehalten ist. Aufgrund der angelegten elektrischen Spannung führen die Piezoelemente dann die erwähnten jeweils kleinen Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Solche bekannte Anordnungen werden häufig als Aktormodule zur Einbringung von Kraftstoff in direkt einspritzende Dieselmotoren als sogenannte Common Rail Systeme eingesetzt. Bei diesen als Common Rail Injektoren bekannten Systemen kann dabei der Einspritzdruck auf einfache Weise an die Last und Drehzahl des Verbrennungsmotors angepasst werden.

Diese Common Rail Injektoren können dabei so aufgebaut werden, dass eine indirekt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist.

Insbesondere bei solchen Einspritzsystemen ist es wichtig, dass der relativ empfindliche Piezoaktor im Inneren eines Haltekörpers medienbeständig aufgebaut ist. Der Piezoaktor muss dabei gegenüber den verschiedenen Kraftstoffen als auch gegenüber wechselnden Drücken und Temperaturen resistent sein. Weiterhin ist bei der Montage und beim Transport ein sicheres Handling erforderlich und zusätzlich ist auch noch ein Schutz vor mechanischem Stoß oder Druck insbesondere hinsichtlich der elektrischen Isolierung notwendig.

Um eine elektrische und mechanische Isolierung des Piezoaktors zu erreichen, wird oft eine Ummantelung des Piezoaktormoduls vorgeschlagen. Aus der DE 10230032 A1 ist zur Vermeidung der zuvor beschriebenen Nachteile eine Anordnung mit einem Piezoaktor in umströmenden Medien bekannt, bei der die Keramikschichten des Piezoelements in einer formveränderlichen Isolationsmasse vergossen sind, die wiederum in einem seitlich und am oberen und unteren Ende gegenüber dem Medium verschlossenen metallischen Gehäusemantel als Hülse eingebracht ist.

DE 19818068 A1 offenbart einen piezoelektronischen Aktor für einen Stellantrieb, wobei der Aktor ein Hohlprofil aufweist, das durch eine elastische Masse ausgefüllt ist.

WO 2007/131965 A1 offenbart einen Piezoaktor mit einem Piezoelement, wobei die Oberfläche des Piezoelements mit einer ersten elektronischen Isolationsschicht versehen und der Piezoaktor zumindest im Bereich des Piezoelements mit mindestens einer Lage einer metallischen Folie umwickelt ist. Auf die Folie und die Verbindungsstellen zum Aktorkopf und zum Aktorfuß überlagernd ist eine Lage eines Kunststoffes aufgetragen.

Zu beachten ist hierbei vor allem das Problem der Abdichtung der Ummantelung am Piezoaktor oder insbesondere auch am Aktorfuß oder am Aktorkopf des Aktormoduls, die in der Regel aus Stahl oder auch aus Keramik sind, und/oder auch an inaktiven keramischen Bereichen des Piezoaktors, um die Anordnung auch hier vor mechanischen Einflüssen und/oder dem Eindringen von Flüssigkeit zu schützen.

### Offenbarung der Erfindung

Die Erfindung geht von einem eingangs beschriebenen Piezoaktormodul oder Piezoaktor aus, wobei das Piezoaktormodul aus einem Aktorfuß und einem Aktorkopf und dazwischen eingefassten Piezoelementen als Piezoaktor besteht. Es ist ein Schutzschichtsystem aus einem mindestens den Piezoaktor umgebenden, insbesondere elektrisch isolierenden Isolationsmedium und einer darüberliegenden metallischen Ummantelung vorhanden, bei dem gemäß Anspruch 1 in vorteilhafter Weise die metallische Ummantelung ausschließlich im Bereich der Anbindung an den Aktorfuß oder den Aktorkopf jeweils mit einer radial umlaufenden Kunststoffumspritzung versehen ist, wobei die Kunststoffumspritzung radial umlaufend eine flüssigkeitsdichte Verbindung sowohl mit der metallischen Ummantelung als auch mit dem Aktorfuß und dem Aktorkopf bildet.

Gemäß der in Anspruch 2 angegebenen Form der Erfindung weist die metallische Ummantelung in vorteilhafter Weise ausschließlich im Bereich der Anbindung an inaktive Bereiche des Piezoaktors die radial umlaufende Kunststoffumspritzung auf, wobei die Kunststoffumspritzung radial umlaufend hier eine flüssigkeitsdichte Verbindung sowohl mit der metallischen Ummantelung als auch mit den inaktiven Bereichen des Piezoaktors bildet. Dies kann in beiden Fällen auf einfache Weise mittels eines werkzeuggebundenen Umspritzen oder Umgießen an den Piezoaktor oder das Aktormodul erfolgen.

Besonders vorteilhaft ist es, wenn die Kunststoffumspritzung auf der Basis von Epoxiden, vorzugsweise mit einer Epoxidmoldmasse, hergestellt ist, die eine sehr gute Haftung insbesondere auf metallischen Oberflächen aufweist.

Die metallische Ummantelung kann auf einfache Weise aus einer metallischen Hülse oder aus einer vorzugsweise dünnen Metallfolie bestehen, die herumgelegt oder auch gewickelt werden kann. Die zuvor beschriebe Anbindung der metallischen Ummantelung an den Piezoaktor oder an den Aktorfuß und/oder den Aktorkopf des Piezoaktormoduls ist insbesondere dadurch vorteilhaft, da ein üblicherweise vorgenommenes Verschweißen oft nicht möglich oder nicht vorteilhaft ist. Die metallische Ummantelung, zum Beispiel die Metallfolie, ist oft für ein Verschweißen zu dünn oder ist aufgrund ihrer Materialeigenschaften nicht zum Verschweißen geeignet. Der Aktorfuß und/oder der Aktorkopf sind gegebenenfalls auch aus Keramik, wie die inaktiven Bereiche des Piezoaktors, und sind damit ebenfalls nicht zum Verschweißen geeignet.

Mit der Erfindung ist somit ein kostengünstig herstellbarer Piezoaktor oder ein Piezoaktormodul gebildet, die Bestandteil eines Piezoinjektors für ein Einspritzsystem für Kraftstoff bei einem Verbrennungsmotor sein können, wobei der Kraftstoff das Schutzschichtsystem ohne Nachteile umströmen kann. Durch die vorgeschlagene Ummantelung ist der erfindungsgemäße Piezoaktor oder das Piezoaktormodul einfach herzustellen, äußerst medienbeständig und gewährleistet außerdem ein sicheres Handling beim Transport und bei der Montage.

### Kurze Beschreibung der Zeichnungen

Ausführungsbeispiele des erfindungsgemäßen Piezoaktormoduls werden anhand der Zeichnungen erläutert. Es zeigen:
Figur 1 einen Schnitt durch Teile eines bekannten Piezoinjektors mit einem ummantelten Piezoaktormodul mit einem Aktorkopf, Piezoelementen als Piezoaktor und einem Aktorfuß,
Figur 2 einen Teilschnitt durch ein ummanteltes Piezoaktormodul mit einer erfindungsgemäßen Anbindung der metallischen Ummantelung an den Aktorkopf und den Aktorfuß mittels einer Kunststoffumspritzung und
Figur 3 einen Teilschnitt durch einen ummantelten Piezoaktor mit einer erfindungsgemäßen Anbindung der metallischen Ummantelung an inaktive keramische Bereiche des Piezoaktors.

### Ausführungsformen der Erfindung

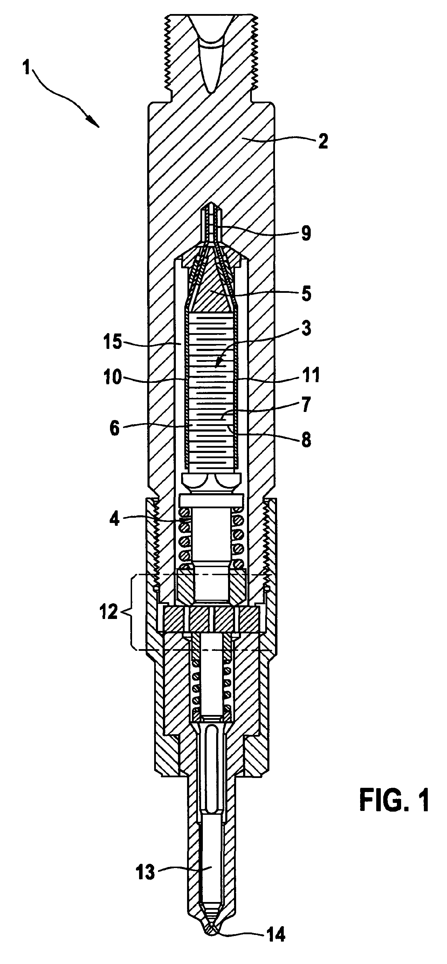

Ein in Figur 1 zur Erläuterung der erfindungsgemäßen Anordnung dargestellter an sich bekannter Piezoinjektor 1 umfasst im Wesentlichen einen Haltekörper 2 und einen in dem Haltekörper 2 angeordnetes Piezoaktormodul 3, das unter anderem einen Aktorkopf 4 und einen Aktorfuß 5 aufweist. Es sind dabei zwischen dem Aktorkopf 4 und dem Aktorfuß 5 mehrere übereinander gestapelte Piezoelemente 6 zur Bildung des eigentlichen Piezoaktors vorhanden, die jeweils aus Piezolagen aus Piezokeramik und diese einschließende Innenelektroden 7 und 8 bestehen.

Die Innenelektroden 7 und 8 der Piezoelemente 6 sind mit Außenelektroden 10 und 11 und dann über ein Steckerteil 9 elektrisch kontaktiert. Das Piezoaktormodul 3 ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Piezoaktormodul 3 wird bei der dargestellten Anwendung nach der Figur 1 als Piezoinjektor 1 in einem Raum 15 von dem mit dem Piezoinjektor 1 zu dosierenden Kraftstoff für einen Verbrennungsmotor umströmt.

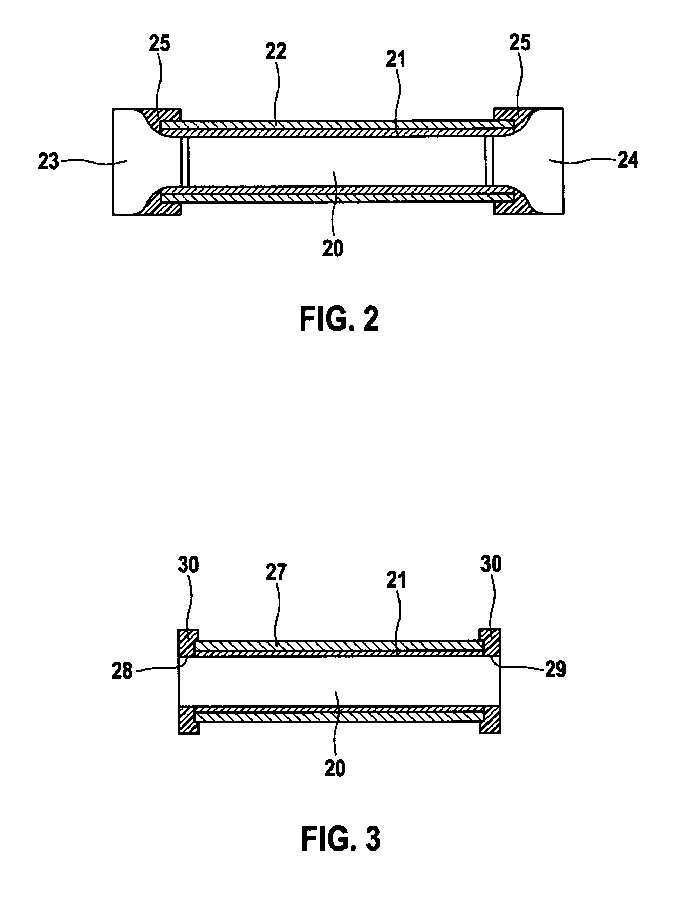

In Figur 2 ist ein Piezoaktor 20 gezeigt, bei dem die Piezoelemente hier nicht im Einzelnen dargestellt sind, der mit einem elektrisch isolierenden Isolationsmedium 21 umgeben ist und darüber befindet sich ein Schutzschichtsystem, das im wesentlichen aus einer metallischen Ummantelung 22, beispielsweise einer Metallfolie oder einer Metallhülse, besteht. Die metallische Ummantelung 22 reicht hier bis an einen Aktorkopf 23 und einen Aktorfuß 24 und ist dort jeweils über einer Kunststoffumspritzung 25, vorzugsweise aus einer Epoxidmoldmasse, radial an den Aktorkopf 23 und den Aktorfuß 24 angebunden.

Aus Figur 3 ist auch der Piezoaktor 20 zu entnehmen, bei dem ebenfalls die Piezoelemente hier nicht im Einzelnen dargestellt sind. Auch hier ist der Piezoaktor 20 mit einem elektrisch isolierenden Isolationsmedium 21 umgeben und darüber befindet sich ein Schutzschichtsystem, das im wesentlichen aus einer metallischen Ummantelung 27, beispielsweise einer Metallfolie oder einer Metallhülse, besteht. Die metallische Ummantelung 27 reicht hier jedoch nur bis an inaktive Bereiche 28 und 29 des Piezoaktors 20 heran und ist dort jeweils über eine Kunststoffumspritzung 30, vorzugsweise aus einer Epoxidmoldmasse, radial an die inaktive Bereiche 28 und 29 des Piezoaktors 20 angebunden.

Mit den erfindungsgemäßen Kunststoffumspritzungen 25 und 30 kann eine sehr gute Haftung auf metallischen Oberflächen am Aktorkopf 23 und am Aktorfuß 24 sowie auf keramischen Oberflächen an den inaktiven Bereiche 28 und 29 des Piezoaktors 20 hergestellt werden, so dass eine insbesondere flüssigkeitsdichte und mechanisch feste Ummantelung des empfindlichen Piezoaktors 20 in den erfindungsgemäßen Bereichen erreicht ist.

## Patentansprüche

1. Piezoaktormodul, bestehend aus einem Aktorfuß (5) und einem Aktorkopf (4) und dazwischen eingefassten Piezoelementen (6) als Piezoaktor sowie mit einem Schutzschichtsystem aus einem mindestens den Piezoaktor umgebenden Isolationsmedium und einer darüberliegenden metallischen Ummantelung, **dadurch gekennzeichnet, dass** die metallische Ummantelung (22;27) ausschließlich im Bereich der Anbindung an den Aktorfuß (24) und den Aktorkopf (23) jeweils mit einer Kunststoffumspritzung (25) versehen ist, wobei die Kunststoffumspritzung (25) radial umlaufend eine flüssigkeitsdichte Verbindung sowohl mit der metallischen Ummantelung (22) als auch mit dem Aktorfuß (24) und dem Aktorkopf (23) bildet.

2. Piezoaktor mit Piezoelementen (6) und mit einem Schutzschichtsystem aus einem mindestens die Piezoelemente (6) umgebenden Isolationsmedium und einer darüberliegenden metallischen Ummantelung, **dadurch gekennzeichnet, dass** die metallische Ummantelung (27) ausschließlich im Bereich der Anbindung an inaktive Bereiche (28,29) des Piezoaktors (20) mit einer Kunststoffumspritzung (30) versehen ist, wobei die Kunststoffumspritzung (30) radial umlaufend eine flüssigkeitsdichte Verbindung sowohl mit der metallischen Ummantelung (27) als auch mit den inaktiven Bereichen (28,29) des Piezoaktors (20) bildet.

3. Piezoaktor oder Piezoaktormodul nach Anspruch 1 oder 2, **dadurch gekennzeichnet, dass** die Kunststoffumspritzung (25;30) auf der Basis von Epoxiden, vorzugsweise als eine Epoxidmoldmasse, hergestellt ist.

4. Piezoaktor oder Piezoaktormodul nach einem der vorhergehenden Ansprüche, **dadurch gekennzeichnet, dass** die metallische Ummantelung (22;27) aus einer metallischen Hülse besteht.

5. Piezoaktor oder Piezoaktormodul nach einem der Ansprüche 1 bis 3, **dadurch gekennzeichnet, dass** die metallische Ummantelung (22;27) aus einer Metallfolie besteht.

6. Verwendung eines Piezoaktor oder eines Piezoaktormoduls nach einem der vorhergehenden Ansprüche, **dadurch gekennzeichnet, dass** der Piezoaktor (20) oder das Piezoaktormodul Bestandteil eines Piezoinjektors für ein Einspritzsystem für Kraftstoff bei einem Verbrennungsmotor ist, wobei der Kraftstoff das Schutzschichtsystem umströmt.

## Claims

1. Piezoactuator module, consisting of an actuator foot (5) and an actuator head (4) and of piezoelements (6) framed between them, as a piezoactuator, and also with a protection layer system composed of an insulating medium surrounding at least the piezoactuator and of a metallic cladding lying over it, **characterized in that** the metallic cladding (22; 27) is provided solely in the region of the tie-up to the actuator foot (24) and to the actuator head (23) in each case with a plastic injection-moulded surround (25), the plastic injection-moulded surround (25) forming radially continuously a liquid-tight connection both with the metallic cladding (22) and with the actuator foot (24) and the actuator head (23).

2. Piezoactuator with piezoelements (6) and with a protection layer system composed of an insulating medium surrounding at least the piezoelements (6) and of a metallic cladding lying over it, **characterized in that** the metallic cladding (27) is provided solely in the region of the tie-up to inactive regions (28, 29) of the piezoactuator (20) with a plastic injection-moulded surround (30), the plastic injection-moulded surround (30) forming radially continuously a liquid-tight connection both with the metallic cladding (27) and with the inactive regions (28, 29) of the piezoactuator (20).

3. Piezoactuator or piezoactuator module according to Claim 1 or 2, **characterized in that** the plastic injection-moulded surround (25; 30) is produced on the basis of epoxides, preferably as an epoxide mould mass.

4. Piezoactuator or piezoactuator module according to one of the preceding claims, **characterized in that** the metallic cladding (22; 27) consists of a metallic sleeve.

5. Piezoactuator or piezoactuator module according to one of Claims 1 to 3, **characterized in that** the metallic cladding (22; 27) consists of a metal foil.

6. Use of a piezoactuator or of a piezoactuator module according to one of the preceding claims, **characterized in that** the piezoactuator (20) or piezoactuator module is an integral part of a piezoinjector for an injection system for fuel in an internal combustion engine, the fuel flowing around the protection layer system.

## Revendications

1. Module de piézoactionneur constitué d'un pied d'actionneur (5) et d'une tête d'actionneur (4) entre lesquels sont sertis des piézoéléments (6) servant de piézoactionneur, ainsi que d'un système de couches de protection constitué d'un milieu isolant qui entoure au moins le piézoactionneur et sur lequel est placée une enveloppe métallique,
**caractérisé en ce que**
exclusivement au niveau de la liaison avec le pied d'actionneur (24) et la tête d'actionneur (23), l'enveloppe métallique (22; 27) est dotée d'une encapsulation (25) en matière synthétique, l'encapsulation (25) en matière synthétique formant radialement et périphériquement une liaison étanche aux liquides à la fois avec l'enveloppe métallique (22), le pied d'actionneur (24) et la tête d'actionneur (23).

2. Piézoactionneur présentant des piézoéléments (6) et un système de couches de protection constitué d'un milieu isolant qui entoure au moins les piézoéléments (6) et sur lequel est placée une enveloppe métallique, **caractérisé en ce qu'**exclusivement au niveau de la liaison à des parties inactives (28, 29) du piézoactionneur (20), l'enveloppe métallique (27) est dotée d'une encapsulation (30) en matière synthétique, l'encapsulation (30) en matière synthétique formant radialement et périphériquement une liaison étanche aux liquides à la fois avec l'enveloppe métallique (27) et avec les parties inactives (28, 29) du piézoactionneur (20).

3. Piézoactionneur ou module de piézoactionneur selon les revendications 1 ou 2, **caractérisé en ce que** l'enveloppe (25; 30) en matière synthétique est réalisée à base d'époxy et de préférence présente la forme d'une pâte époxy de moulage.

4. Piézoactionneur ou module de piézoactionneur selon l'une des revendications précédentes, **caractérisé en ce que** l'enveloppe métallique (22; 27) est constituée d'une douille métallique.

5. Piézoactionneur ou module de piézoactionneur selon l'une des revendications 1 à 3, **caractérisé en ce que** l'enveloppe métallique (22; 27) est constituée d'une feuille métallique.

6. Utilisation d'un piézoactionneur ou d'un module de piézoactionneur selon l'une des revendications précédentes, **caractérisée en ce que** le piézoactionneur (20) ou le module de piézoactionneur font partie d'un piézo-injecteur pour système d'injection de carburant d'un moteur à combustion interne, le carburant balayant le système de couches de protection.
